(19) Europäisches Patentamt

European Patent Office

Office européen des brevets

(11) Veröffentlichungsnummer: **0 258 517 B1**

(12) **EUROPÄISCHE PATENTSCHRIFT**

(45) Veröffentlichungstag der Patentschrift: **08.04.92**

(21) Anmeldenummer: **87100708.4**

(22) Anmeldetag: **20.01.87**

(51) Int. Cl.⁵: **G01R 31/02**, G01R 19/14

(54) Verfahren und Einrichtung zur Erkennung der Polarität gepolter Kondensatoren.

(30) Priorität: **01.08.86 DE 3626036**

(43) Veröffentlichungstag der Anmeldung:
**09.03.88 Patentblatt 88/10**

(45) Bekanntmachung des Hinweises auf die
Patenterteilung:
**08.04.92 Patentblatt 92/15**

(84) Benannte Vertragsstaaten:
**CH DE GB LI**

(56) Entgegenhaltungen:
**EP-A- 0 185 255**
**GB-A- 1 016 713**

**IBM TECHNICAL DISCLOSURE BULLETIN,
Band 27, Nr. 10A, März 1985, Seiten
5654-5655, New York, US; "Circuit for determining electrolytic capacitor polarity"**

(73) Patentinhaber: **SIEMENS AKTIENGESELL-
SCHAFT**
**Wittelsbacherplatz 2**
**W-8000 München 2(DE)**

(72) Erfinder: **Aldinger, Ulrich**
**Zittelstr. 4**
**W-8000 München 40(DE)**

Rank Xerox (UK) Business Services

## Beschreibung

Die Erfindung betrifft ein Verfahren zur Erkennung der Polarität gepolter Kondensatoren, insbesondere von Tantal- und Aluminium-Elektrolytkondensatoren bei der automatischen Bestückung von Leiterplatten oder Keramiksubstraten, bei dem ein zu prüfender Kondensator abwechselnd mit einem konstanten Gleichstrom der einen Richtung und mit einem konstanten Gleichstrom gleichen Betrags der anderen Richtung auf eine vorgebbare positive Spannung bzw. eine vorgebbare negative Spannung gleichen Betrags aufgeladen wird, sowie eine Einrichtung zur Durchführung dieses Verfahrens.

Bei der automatischen Bestückung von Leiterplatten und Keramiksubstraten mit elektronischen Bauteilen, wie Widerständen, Kondensatoren, Dioden, Transistoren, Chips und dergleichen werden die verschiedenen Bauteile in seitlich angeordneten Zuführeinrichtungen bereitgestellt. Die Entnahme der Bauteile erfolgt dann über einen Bestückkopf, welcher das jeweils in einer Entnahmeposition bereitgestellte Bauteil erfaßt, mit Hilfe von vier paarweise angeordneten, zangenförmigen Hebeln zentriert und auf einer vorbestimmten Stelle der Leiterplatte oder des Keramiksubstrats ablegt. Die mit derartigen, beispielsweise aus der US-A- 4 135 630 bekannten Bestückautomaten erzielbare Bestückungssicherheit hängt in entscheidender Weise davon ab, daß der auf die Entnahmeposition der Zuführeinrichtungen programmierte Bestückkopf die Bauteile dort auch stets in der richtigen Lage antrifft und in der programmierten Bestückposition der Leiterplatte oder des Keramiksubstrats ebenfalls in der richtigen Lage ablegt.

Bei einem aus der DE-A- 3 102 206 bekannten Bestückkopf besteht zumindest das untere Ende der zur Aufnahme der Bauteile dienenden Saugpipette aus elektrisch nichtleitendem Werkstoff, wobei die mit dem elektronischen Bauteil zusammenwirkenden zangenförmigen Enden der Hebel elektrisch isoliert angeordnet sind. Durch diese Maßnahme kann dann über ein Hebelpaar ein bestimmter Strom eingespeist werden oder es kann über ein Hebelpaar eine bestimmte Spannung angelegt werden. Insbesondere besteht die Möglichkeit die elektrischen Eigenschaften des jeweils vom Bestückkopf erfaßten Bauteils zu messen bzw. zu prüfen. Eine für die automatische Bestückung unbedingt erforderliche Erkennung der Polarität gepolter Kondensatoren ist mit dem geschilderten Bestückkopf jedoch nicht möglich, da bislang keine geeigneten elektrischen Erkennungsverfahren bekannt sind.

Aus IBM Technical Disclosure Bulletin, Band 27, Nr. 10 A, März 1985, Seiten 5654, 5655 sind ein Verfahren und eine Einrichtung zur Erkennung der Polarität gepolter Kondensatoren bekannt, bei welchen ein zu prüfender Kondensator mit Hilfe einer Konstantstromquelle abwechselnd mit einem konstanten Gleichstrom der einen Richtung und mit einem konstanten Gleichstrom gleichen Betrags der anderen Richtung auf eine vorgebbare positive Spannung bzw. eine vorgebbare negative Spannung gleichen Betrags aufgeladen wird. Die Aufladung des zu prüfenden Kondensators erfolgt jeweils über eine zur Konstantstromquelle parallel geschaltete Zenerdiode und einen mit dieser Zenerdiode in Reihe geschalteten Widerstand, wobei der durch den Widerstand fließende Strom mit einer Strommeßeinrichtung erfaßt wird. Liegt der durch die Aufladung des Kondensators bewirkte Durchbruch der Zenerdiode innerhalb eines bestimmten Zeitintervalls, so kann hieraus auf die korrekte Orientierung des Kondensators geschlossen werden.

Der Erfindung liegt die Aufgabe zugrunde, ein Verfahren und eine Einrichtung zur Erkennung der Polarität gepolter Kondensatoren zu schaffen, welche insbesondere bei der automatischen Bestückung von Leiterplatten oder Keramiksubstraten eine einfache und zuverlässige Polaritätserkennung von Tantal- und Aluminium-Elektrolytkondensatoren ermöglichen.

Diese Aufgabe wird bei einem Verfahren der eingangs genannten Art erfindungsgemäß dadurch gelöst, daß jeweils die zum Aufladen und/oder Entladen des Kondensators benötigten Zeiten gemessen werden und daß aus der Differenz der gemessenen Zeiten die Polarität des Kondensators bestimmt wird.

Der Erfindung liegt die Erkenntnis zugrunde, daß bei einer richtigen Polung von Elektrolytkondensatoren eine kleinere Kapazität gemessen wird als bei einer falschen Polung. Dies ist darauf zurückzuführen, daß bei einer richtigen Polung das aus einer Metalloxidschicht bestehende Dielektrikum durch Sauerstoffaufnahme gestärkt wird, während sich bei einer falschen Polung durch Sauerstoffentzug eine Schwächung ergibt. Die Verringerung der Stärke des Dielektrikums führt dann zwangsläufig zu einer höheren Kapazität. Demzufolge wird dann bei richtiger Polung des Kondensators der Kondensator gegenüber einer falschen Polung um etwa 1 % schneller geladen. In gleicher Weise wird bei richtiger Polung des Kondensators der Kondensator gegenüber einer falschen Polung um etwa 1 % schneller entladen. Obwohl die Unterschiede der für das Aufladen und/oder Entladen bei richtiger und falscher Polung benötigten Zeilen gering sind, können durch den Vergleich beider Zeitmessungen absolut zuverlässige Aussagen über die Polarität der gemessenen Kondensatoren gewonnen werden.

Gemäß einer weiteren Ausgestaltung der Erfindung werden für die Aufladung des Kondensators eine positive Spannung von +0,5 Volt und eine negative Spannung von -0,5 Volt vorgegeben. Dabei wurde berücksichtigt, daß die Spannung auf die der Kondensators geladen wird möglicht hoch sein sollte um eine möglichst deutliche Aussage über die Polarität zu erzielen. Andererseits wurde bei dieser Bemessung berücksichtigt, daß die gepolten Kondensatoren bei Überschreiten bestimmter maximaler Umpolspannungen zerstört werden. Bei Tantal-Elektrolytkondensatoren betragen die maximal zulässigen Umpolspannungen 0,15 $U_{Nenn}$ bei 20°C und 0,05 $U_{Nenn}$ bei 80°C, während bei Aluminium-Elektrolytkondensatoren die maximal zulässige Umpolspannung 2 Volt beträgt. Da die Aufladungen der Kondensatoren auf + 0,5 Volt bei Zimmertemperatur vorgenommen werden, führt die Polaritätserkennung mit Sicherheit zu keinen Schädigungen der Kondensatoren.

Eine besonders einfach aufgebaute und zuverlässige Einrichtung zur Durchführung des erfindungsgemäßen Verfahrens, bei der am dem zu prüfenden Kondensator die Ausgänge einer Konstantstromquelle zum abwechselnden Einspeisen eines konstanten Gleichstroms der einen Richtung und eines konstanten Gleichstroms gleichen Betrags der anderen Richtung angeschlossen sind, wobei der Kandensator auf eine vorgebbare positive Spannung bzw. eine vorgebbare negative Spannung gleichen Betrags aufgeladen wird, ist dadurch gekennzeichnet, daß eine Zeitmeßeinrichtung zum Erfassen der zum Aufladen und/oder Entladen des Kondensator jeweils benötigten Zeiten mit dem Kondensator verbunden ist und daß die Differenz dieser Zeiten repräsentativ für die jeweilige Polarität des Kondensators ist.

Gemäß einer bevorzugten Ausgestaltung der erfindungsgemäßen Einrichtung ist vorgesehen, daß die Zeitmeßeinrichtung durch einen von drei Komparatoren steuerbaren Zähler gebildet ist. Mit einer derartigen Kombination aus Komparatoren und Zähler werden besonders genaue Zeitmessungen der Aufladevorgänge und/oder Entladevorgänge ermöglicht.

Ein Ausführungsbeispiel der Erfindung ist in der Zeichnung dargestellt und wird im folgenden näher beschrieben:

Es zeigen

Fig. 1      einen Bestückkopf mit einem gepolten Kondensator und einer Polaritäts-Erkennungseinrichtung,

Fig. 2      das Prinzip der Polaritätserkennung und

Fig. 3      den prinzipiellen Aufbau der in Fig. 1 dargestellten Polaritäts-Erkennungseinrichtung.

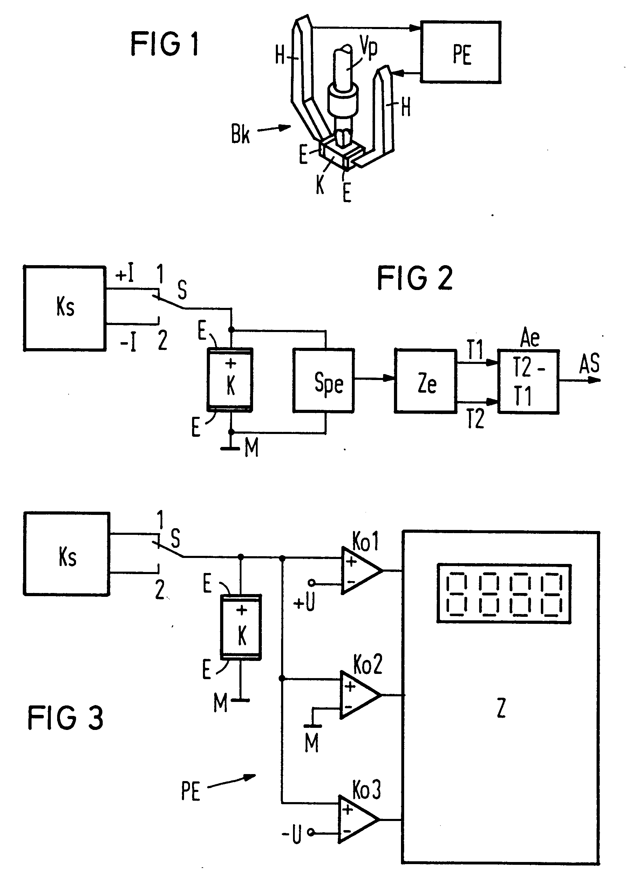

Fig. 1 zeigt einen von dem Bestückkopf Bk eines Bestückautomaten erfaßten Kondensator K. Von dem Bestückkopf Bk sind dabei lediglich eine Vakuumpipette Vp und zwei der insgesamt vier zur Zentrierung der aufgenommenen Bauteile vorgesehenen Hebel H zu erkennen.

Bei dem in Fig. 1 dargestellten Kondensator K handelt es sich um einen als SMD-Bauteil ausgebildeten gepolten Kondensator, beispielsweise um einen Tantal-Elektrolytkondensator. Somit ist eine der stirnseitigen Elektroden E dem positiven Pol und die andere Elektrode E dem negativen Pol zugeordnet. Da die lediglich auf einer Seite durch ein aufgedrucktes "+" aufgezeigte Polarität des Kondensators K vom Bestückautomaten nicht erkannt werden kann, ist dem Bestückkopf eine Polaritäts-Erkennungseinrichtung PE zugeordnet. Diese Polaritäts-Erkennungseinrichtung PE ist dabei an die beiden Hebel H angeschlossen, deren zangenförmige Enden die Elektroden E des vom Bestückkopf Bk aufgenommenen gepolten Kondensators K kontaktieren.

Fig. 2 zeigt in stark vereinfachter schematischer Darstellung das erfindungsgemäße Prinzip der Polaritätserkennung. Eine mit Ks bezeichnete Konstantstromquelle erzeugt einen konstanten Strom +I der einen Richtung und einen vom Betrag her gleich großen konstanten Strom -I der anderen Richtung. Dieser konstante Strom +I oder -I wird je nach Stellung eines Schalters S in den Kondensator K eingespeist, dessen Elektroden an den Schalter S bzw. an Masse M angeschlossen sind. In der in Fig. 2 dargestellten Stellung 1 des Schalters S wird in dem zu messenden Kondensator K der "positive" konstante Strom +I eingespeist. Eine parallel zum Kondensator K geschaltete Spannungsmeßeinrichtung Spe schaltet eine nachgeordnete Zeitmeßeinrichtung Ze mit Beginn des Ladevorganges ein. Sobald der Kondensator dann auf eine positive Spannung +U von +0,5 Volt aufgeladen ist, schaltet die Spannungsmeßeinrichtung Spe die Zeitmeßeinrichtung Ze wieder ab, wobei die für den Ladevorgang gemessene Zeit mit T1 bezeichnet ist.

In der Stellung 2 des Schalters S wird in dem zu messenden Kondensator K dann der "negative" konstante Strom -I eingespeist. Die Spannungsmeßeinrichtung Spe schaltet die Zeitmeßeinrichtung Ze nach vorhergehender Entladung des Kondensators K mit Beginn des erneuten Ladevorganges ein. Sobald der Kondensator dann auf eine negative Spannung -U von -0,5 Volt aufgeladen ist, schaltet die Spannungsmeßeinrichtung Spe die Zeitmeßeinrichtung Ze wieder ab, wobei die für diesen Ladevorgang gemessene Zeit mit T2 bezeichnet ist.

Die beiden gemessenen Zeiten T1 und T2 werden einer Auswerteeinrichtung Ae zugeführt, welche ein der Differenz T2 - T1 entsprechendes Ausgangs-Signal AS erzeugt, welches für die Polarität des jeweiligen Kondensators K repräsentativ ist und beispielsweise dem Rechner des Bestückautomaten zugeführt wird.

Basierend auf der Erkenntnis, daß gepolte Kondensatoren K bei richtiger Polung schneller aufgeladen werden als bei einer falschen Polung ergibt sich für den in Fig. 2 dargestellten Fall, daß bei T1 < T2 eine richtige Polung angenommen werden kann, während bei T1 > T2 eine falsche Polung des Kondensators K angezeigt wird.

Gemäß Fig. 2 ist die obere Elektrode E des Kondensators K mit "+" bezeichnet, wobei der Bestückautomat diese Kennzeichnung der Polarität jedoch nicht erkennen kann. Die richtige Polarität wird jedoch dem Bestückautomaten durch das Ausgangs-Signal AS = T2 - T1 angezeigt. Im dargestellten Fall ist T1 < T2, d. h. der positive Wert des Ausgangs-Signals As zeigt an, daß der Kondensator K in der Stellung 1 des Schalters S die richtige Polarität mit der kleineren Ladezeit aufweist. Da in der Stellung 1 des Schalters S an der in Fig. 2 oberen Elektrode des Kondensators K ein "positiver" Strom +I eingespeist wird ergibt sich, daß die obere Elektrode E dem Pluspol und die untere Elektorde E dem Minuspol zugeordnet ist.

Fig. 3 zeigt dem Aufbau der in Fig. 1 dargestellten Polaritäts-Erkennungseinrichtung PE, wobei die Anordnung einer Konstantstromquelle Ks und des Kondensators K der bereits in Fig. 2 gezeigten Anordnung entspricht. Der Schalter S bzw. die obere Elektrode E ist an die positiven Eingänge von Komparatoren Ko1, Ko2, und Ko3 angeschlossen. An den negativen Eingang des Komparators Ko1 ist als Referenzspannung +U eine Spannung von +0,5 Volt angelegt. Der negative Eingang des Komparators Ko2 ist an Masse M angelegt, d.h. die Referenzspannung beträgt hier Null Volt. An den negativen Eingang des Komparators Ko3 ist als Referenzspannung -U eine Spannung von -0,5 Volt angelegt. Die Ausgänge der drei Komparatoren Ko1, Ko2 und Ko3 sind an einen Zähler Z angeschlossen.

In der Stellung 1 des Schalters S schaltet der Komparator Ko2 zu Beginn des Ladevorganges bei entladenem Kondensator K den Zähler Z ein. Sobald der Kondensator K auf +0,5 Volt aufgeladen ist, schaltet dann der Komparator Ko1 den Zähler Z wieder aus. Nach dem Umschalten des Schalters S in die Stellung 2 schaltet der Komparator Ko2 zu Beginn des erneuten Ladevorganges bei entladenem Kondensator K den Zähler Z wieder ein. Sobald der Kondensator K auf -0,5 Volt aufgeladen ist, schaltet dann der Komparator Ko3 den Zähler Z wieder aus. Demnach ermittelt der Zähler Z die in Fig. 2 mit T1 und T2 bezeichneten Ladezeiten. Für die Messung könnten aber auch die Entladezeiten zusätzlich oder sogar allein herangezogen werden. Die weitere Auswertung der mit dem Zähler Z ermittelten Zeiten kann auf die bereits im Zusammenhang mit Fig. 2 beschriebene Weise vorgenommen werden.

## Patentansprüche

1. Verfahren zur Erkennung der Polarität gepolter Kondensatoren (K), insbesondere von Tantal- und Aluminium-Elektrolytkondensatorenbei der automatischen Bestückung von Leiterplatten oder Keramiksubstraten, bei dem ein zu prüfender Kondensator (K) abwechselnd mit einem konstanten Gleichstrom (+I) der einen Richtung und mit einem konstanten Gleichstrom (-I) gleichen Betrags der anderen Richtung auf eine vorgebbare positive Spannung (+U) bzw. eine vorgebbare negative Spannung (-U) gleichen Betrags aufgeladen wird, **dadurch gekennzeichnet,** daß jeweils die zum Aufladen und/oder Entladen des Kondensators (K) benötigten Zeiten (T1, T2) gemessen werden und daß aus der Differenz der gemessenen Zeiten (T2 - T1) die Polarität des Kondensators (K) bestimmt wird.

2. Verfahren nach Anspruch 1, dadurch **gekennzeichnet,** daß für die Aufladung des Kondensators (K) eine positive Spannung (+U) von +0,5 Volt und eine negative Spannung von -0,5 Volt vorgegeben werden.

3. Einrichtung zur Durchführung des Verfahrens nach Anspruch 1 oder 2, bei der am den zu prüfenden Kondensator (K) die Ausgänge Kon-stantstromquelle (Ks) zum abwechselnden Ein-speisen eines konstanten Gleichstroms (+I) der einen Richtung und eines konstanten Gleichstroms (-I) gleichen Betrags der anderen Richtung angeschlossen sind, wobei der Kondensator (K) auf eine vorgebbare positive Spannung (+U) bzw. eine vorgebbare negative Spannung (-U) gleichen Betrags aufgeladen wird, **dadurch gekennzeichnet,** daß eine Zeitmeßeinrichtung (Ze) zum Erfassen der zum Aufladen und/oder Entladen des Kondensators (K) jeweils benötigten Zeiten (T1, T2) mit dem Kondensator (K) ververbunden ist und daß die Differenz dieser Zeiten (T2-T1) repräsentativ für die jeweilige Polarität des Kondensators (K) ist.

4. Einrichtung nach Anspruch 3, dadurch **gekennzeichnet,** daß die Zeitmeßeinrichtung (Ze) durch einen von drei Komparatoren (Ko1, Ko2, Ko3) steuerbaren Zähler (Z) gebildet ist.

## Claims

1. Method for identifying the polarity of polarised capacitors (K), preferably of tantalum and aluminium electrolytic capacitors in the automatic fitment of printed-circuit boards or ceramic substrates, in which method a capacitor (K) to be tested is alternately charged with a constant DC current (+I) of the one polarity and with a constant DC current (-I) of the same magnitude but the other polarity, to a positive voltage (+U) which can be predetermined or to a negative voltage (-U), of the same magnitude, which can be predetermined, characterised in that the times (T1, T2) required in each case for charging and/or discharging the capacitor (K) are measured, and in that the polarity of the capacitor (K) is determined from the difference of the measured times (T2 - T1).

2. Method according to Claim 1, characterised in that a positive voltage (+U) of +0.5 volts and a negative voltage of -0.5 volts are predetermined for charging the capacitor (K).

3. Device for carrying out the method according to Claim 1 or 2, in which the outputs of a constant current source (Ks) are connected to the capacitor (K) to be tested, for alternately supplying a constant DC current (+I) of the one polarity and a constant DC current (-I) of the same magnitude but the other polarity, the capacitor (K) being charged to a positive voltage (+U), which can be predetermined or to a negative voltage (-U) of the same magnitude, which can be predetermined, characterised in that a time measuring device (Ze) is connected to the capacitor (K) to identify the times (T1, T2) required in each case for charging and/or discharging the capacitor (K), and in that the difference of these times (T2 - T1) is representative for the respective polarity of the capacitor (K).

4. Device according to Claim 3, characterised in that the time measuring device (Ze) is formed by a counter (Z) which can be controlled by one of three comparators (Ko1, Ko2, Ko3).

**Revendications**

1. Procédé pour identifier la polarité de condensateurs polarisés (K), notamment de condensateurs électrolytiques au tantale et à l'aluminium, lors de l'équipement automatique de plaquettes à circuits imprimés ou de substrats céramiques, selon lequel un condensateur (K) à contrôler est chargé alternativement par un courant continu constant (+I) circulant dans un sens et par un courant continu constant (-I) de même valeur et circulant dans l'autre sens, à une tension positive (+U) pouvant être prédéterminée ou à une tension négative (-U) pouvant être prédéterminée, qui possèdent la même valeur,
caractérisé par le fait qu'on mesure respectivement les durées (T1,T2) nécessaires pour la charge et/ou la décharge du condensateur (K) et qu'on détermine, à partir de la différence des durées mesurées (T2-T1), la polarité du condensateur (K).

2. Procédé selon la revendication 1, caractérisé par le fait qu'une tension positive (+U) de +0,5 volt et une tension négative de -0,5 volt sont prédéterminées pour la charge du condensateur (K).

3. Dispositif pour la mise en oeuvre du procédé suivant la revendication 1 ou 2, dans lequel au condensateur à contrôler (K) sont raccordées les sorties d'une source de courant constant (Ks) servant à envoyer alternativement un courant continu constant (+I) circulant dans un premier sens et un courant continu constant (-I) possédant une valeur identique et circulant dans l'autre sens, le condensateur (K) étant chargé à une tension positive (+U) pouvant être prédéterminée et à une tension négative (-U) pouvant être prédéterminée et possédant la même valeur, caractérisé par le fait qu'un dispositif formant minuterie (Ze) servant à détecter les durées (T1,T2) respectivement nécessaires pour charger et/ou décharger le condensateur (K) est raccordé à ce condensateur (K) et que la différence entre ces durées (T2-T1) est représentative de la polarité du condensateur (K).

4. Dispositif suivant la revendication 3, caractérisé par le fait que le dispositif formant minuterie (Ze) est formé par un compteur (Z) qui peut être commandé par trois comparateurs (Ko1, Ko2, Ko3).

FIG 1

FIG 2

FIG 3